Europäisches Patentamt

European Patent Office

Office européen des brevets

(11) Publication number: **0 181 507 B1**

# EUROPEAN PATENT SPECIFICATION

(45) Date of publication of patent specification: **29.05.91**  (51) Int. Cl.⁵: **G01T 1/29, H01J 37/22**

(21) Application number: **85112937.9**

(22) Date of filing: **11.10.85**

The file contains technical information submitted
after the application was filed and not included in
this specification

(54) **Device for recording images produced by an electron microscope.**

(30) Priority: **12.10.84 JP 214682/84**

(43) Date of publication of application:
**21.05.86 Bulletin 86/21**

(45) Publication of the grant of the patent:
**29.05.91 Bulletin 91/22**

(84) Designated Contracting States:
**DE FR NL**

(56) References cited:
**EP-A- 0 077 676**
**US-A- 3 823 322**

(73) Proprietor: **FUJI PHOTO FILM CO., LTD.**
**210 Nakanuma Minamiashigara-shi**
**Kanagawa-ken, 250-01(JP)**

(72) Inventor: **Hosoi, Yuichi Fuji Photo Film Co.**
**Ltd.**
**798 Miyanodai Kaisei-machi**
**Ashigarakami-gun Kanagawa-ken(JP)**
Inventor: **Miyahara, Junji Fuji Photo Film Co.**
**Ltd.**
**798 Miyanodai Kaisei-machi**
**Ashigarakami-gun Kanagawa-ken(JP)**

(74) Representative: **Kador & Partner**
**Corneliusstrasse 15**
**W-8000 München 5(DE)**

## Description

### BACKGROUND OF THE INVENTION

Field of the Invention

The present invention relates to a device for recording images produced by an electron microscope, and more particularly to an image recording device capable of recording electron microscope images with high sensitivity and of reproducing the recorded electron microscope images in the form of electric signals in order to allow the images to be processed in various ways.

Description of the Prior Art

There are known electron microscopes for obtaining a magnified image of a specimen by deflecting a beam of electrons transmitted through the specimen with an electric or magnetic field. As is well known, the electron beam having passed through the specimen forms a diffraction pattern on the rear focal plane of the objective lens, and the diffracted beams interfere with each other again to produce the magnified image of the specimen. The magnified specimen image can be observed as a scattered-light image by projecting the image onto a screen with a projector lens. Alternatively, the rear focal plane of the objective lens may be projected for enabling the user to observe the magnified diffraction pattern of the image. Where an intermediate lens is positioned between the objective lens and the projector lens, the magnified scattered-light image or the diffraction pattern may be produced selectively as desired by adjusting the focal length of the intermediate lens.

The magnified image or the diffraction pattern (hereinafter referred to collectively as a "transmitted electron-beam image) may be observed in different manners. For example, one general practice has been to place a photographic film on the image formation plane for exposure to the transmitted electron-beam image. According to another design, an image intensifier is employed to amplify the transmitted electron-beam image for projection. The use of photographic films is however disadvantageous in that their sensitivity to electron beams is low and the process of developing the films is complex. The image intensifier also has drawbacks in that the images produced thereby have poor sharpness and are likely to become distorted.

Transmitted electron-beam images are often processed to make them more easier to see. Specifically, the transmitted electron-beam images are subject to various signal processing modes such as tone processing, frequency emphasis, density processing, subtractive processing, and additive processing. The images are also processed to reconstruct three-dimensional images by Fourier analysis, digitize the images, and measure particle diameters. The diffraction patterns are also processed to analyze crystal information and find lattice constants, dislocations, and lattice defects. For such image and diffraction pattern processing, it has been customary to convert the electron microscope image on a developed photographic film into an electric signal with a microphotometer, convert the electric signal into a digital signal, and then process the digital signal with a computer. This process has proven unsatisfactory since it is quite complex. Moreover from US-A- 3,823,322 an improved photographic film handling apparatus for use with charged-particle beam equipment such as electron microscopes is known. This equipment is lacking any erase means.

The EP-A- 0 077 676 describes a radiation image recording system in which a radiation image is recorded on a stimulable phosphor sheet and the noise due to the previously stored radiation image and the fog in the phosphor sheet is erased by a light source in a single erasing operation. The device according to EP-A- 0 077 676 is not concerned with an electron microscope.

Beta-rays are mentioned in the EP-A- 0 077 676 in connection with the cited prior art among other specific and energetically different rays, whose energy can be stored by stimulable phosphors.

### SUMMARY OF THE INVENTION

In view of the aforesaid problems of the prior electron microscope image recording devices, it is an object of the present invention to provide an image recording device capable of recording and reproducing electron microscope images with high sensitivity and quality and of recording electron microscope images in a manner so as to be able to directly produce electric signals representing the images at the subsequent stage of image reproduction.

According to the present invention, there is provided a device for recording images produced by an electron microscope, comprising a sensor supply unit for supplying a two-dimensional sensor comprising a stimulable phosphor sheet capable of storing electron beam energy, a recorder for holding the stimulable phosphor sheet on the image formation plane of the electron microscope and for recording an electron beam image transmitted through a specimen on the two-dimensional sensor, a sensor receiving unit for accommodating the stimulable phosphor sheet having recorded the electron beam image thereon, a sensor feed means for feeding the stimulable phosphor sheet from the sensor supply unit to the recorder, a sensor delivery means for delivering the stimulable phosphor sheet from the recorder to the sensor receiving unit after the electron beam image has been recorded on the stimulable phosphor sheet in the recorder, and an erase means disposed between the sensor supply unit and the recorder for heating or irradiating the stimulable phosphor sheet with light to discharge residual radiation energy stored in the stimulable phosphor sheet.

Throughout this description the expression "two-dimensional sensor" will stand for "stimulable phosphor sheet". A stimulable phosphor sheet is disclosed in EP-B-7105 DE-3007559, DE 29 52 426, EP-B-31952 as well as in Japanese Unexamined Patent Publication No 56-11395 (no prior art in the sense of Art 54(2)) , for example. A certain phosphor, when exposed to a radiation such as an electron beam, stores a part of the energy of the radiation. When the phosphor exposed to the radiation is exposed to stimulating rays such as visible light, the phosphor emits light (stimulated emission) in proportion to the stored energy of the radiation. Such a phosphor is called a stimulable phosphor, and the stimulable phosphor sheet is generally composed of a support and a stimulable phosphor layer disposed on the support. The stimulable phosphor layer may be formed by dispersing the stimulable phosphor in a suitable binder. However, the stimulable phosphor layer may itself be a stimulable phosphor sheet if it is self-supporting.

The two-dimensional sensor may also be in the form of a thermoluminescent phosphor sheet as revealed in Japanese Patent Publication Nos. 55-47719 and 55-47720, for example. The thermoluminescent phosphor sheet emits stored radiation energy as thermoluminescence when heat is applied to the sheet. The thermoluminescent phosphor sheet may be constructed in the same manner as the stimulable phosphor sheet.

The two-dimensional sensor is placed on the image formation plane of the electron microscope, and the electron microscope image is recorded on the two-dimensional sensor by the electron beam transmitted through the specimen. Then, as disclosed in Japanese Patent Application No. 59-150175, the two-dimensional sensor on which the electron microscope image is stored is exposed to stimulating rays such as visible light or is heated to enable the sensor to emit the stored electron beam energy as light. The emitted light is then photoelectrically read to produce an electric signal indicative of the transmitted electron-beam image.

The electric image signal thus generated may be employed to display the electron microscope image on a display unit such as a CRT, or to record the electron microscope image permanently as a hard copy, or to store the electron microscope image on a recording medium such as a magnetic tape, a magnetic disk, or the like.

The electron microscope images can be recorded with high sensitivity by the two-dimensional sensor of the type described above. The electric image signals produced from the two-dimensional sensor can be processed in various modes, such as tone processing and frequency emphasis, for example.

The two-dimensional sensor is fed by the sensor feed means from the sensor supply unit to the image formation plane of the electron microscope. After the electron microscope image has been recorded on the two-dimensional sensor, the sensor is discharged from the image formation plane by the sensor delivery means. A number of two-dimensional sensors may be stored in the sensor supply means, and successively fed for recording a succession of electron microscope images respectively thereon highly efficiently.

In some applications, the stimulable phosphor sheet is recycled in use. However, after an electron microscope image has been read from the stimulable phosphor sheet, the stimulable phosphor sheet may still carry a remanent image thereon. The stimulable phosphor sheet that has been left unused for a long time may contain noise arising from environmental radiation or radiation from radioactive elements such as radium (Ra) mixed as impurities in the phosphor, or a slight trace of the previously recorded image. In the device of the present invention, the residual radiation energy such as the remanent image and/or the noise can be eliminated by the erase means. Therefore, the electron microscope images can be recorded at a high S/N ratio with high image quality.

The stimulable phosphor employed in the stimulable phosphor sheet according to the present invention may comprise phosphors expressed by the composition formulas: SrS:Ce, Sm; SrS:Eu, Sm; $ThO_2$:Er; and $La_2O_2S$:Eu, Sm, as disclosed in U.S. Patent No. 3,859,527.

The stimulable phosphor may also comprise phosphors expressed by the composition formulas: ZnS:Cu,Pb; BaO·$xAl_2O_3$:Eu [where $0.8 \leq x \leq 10$]; and $M^{II}O$ $xSiO_2$:A [where $M^{II}$ is Mg, Ca, Sr, Zn, Cd, or Ba; A is Ce, Tb, Eu, Tm, Pb, Tl, Bi, or Mx; and $0.5 \leq x \leq 2.5$], as disclosed in Japanese Unexamined Patent Publication No. 55(1980)-12142.

The stimulable phosphor may also comprise phosphors expressed by the composition formula: $(Ba_{1-x-y}, Mg_x, Ca_y)FX$:a$Eu^{2+}$ [where X is at least one of Cl and Br; $0 < x + y \leq 0.6$, $xy \neq 0$, and $10^{-6} \leq a$

$\leq 5 \times 10^{-2}$], as disclosed in Japanese Unexamined Patent Publication No. 55(1980)-12143.

The stimulable phosphor may also comprise phosphors expressed by the composition formula: LnOX:xA [where Ln is at least one of La, Y, Gd, and Lu; X is at least one of Cl and Br; A is at leaset one of Ce and Tb; and $0 < x < 0.1$], as disclosed in Japanese Unexamined Patent Publication No. 55-(1980)-12144.

The stimulable phosphor may also comprise phosphors expressed by the composition formula: $(Ba_{1-x}, M^{II})_x FX:yA$ [where $M^{II}$ is at least one of Mg, Ca, Sr, Zn, and Cd, X is at least one of Cl, Br, and I; A is at least one of Eu, Tb, Ce, Tm, Dy, Pr, Ho, Nd, Yb, and Er; $0 \leq x \leq 0.6$, and $0 \leq y \leq 0.2$], as disclosed in Japanese Unexamined Patent Publication No. 55(1980)-12145.

The stimulable phosphor may also comprise phosphors expressed by the composition formula: $M^{II}FX \cdot xA:yLn$ [where $M^{II}$ is at least one of Ba, Ca, Sr, Mg, Zn, and Cd; A is at least one of BeO, MgO, CaO, SrO, BaO, ZnO, $Al_2O_3$, $Y_2O_3$, $La_2O_3$, $In_2O_3$, $SiO_2$, $TlO_2$, $ZrO_2$, $GeO_2$, $SnO_2$, $Nb_2O_5$, $Ta_2O_5$, and $ThO_2$; Ln is at least one of Eu, Tb, Ce, Tm, Dy, Pr, Ho, Nd, Yb, Er, Sm, and Gd; X is at least one of Cl, Br, and I; $5 \times 10^{-5} < x < 0.5$, and $0 < y < 0.2$], as disclosed in Japanese Unexamined Patent Publication No. 55(1980)-160078.

The stimulable phosphor may also comprise phosphors expressed by the composition formula: $(Ba_{1-x}, M^{II}_x)F_2 \cdot aBaX_2:yEu^{2+}, zA$ [where $M^{II}$ is at least one of beryllium, magnesium, calcium, strontium, zinc, and cadmium; X is at least one of chlorine, bromine, and iodine; A is at least one of zirconium and scandium; $0.5 \leq a \leq 1.25, 0 \leq x \leq 1, 10^{-6} \leq y \leq 2 \times 10^{-1}$, and $0 < z \leq 10^{-2}$], as disclosed in Japanese Unexamined Patent Publication No. 56(1981)-116777.

The stimulable phosphor may also comprise phosphors expressed by the composition formula: $(Ba_{1-x}, M^{II}_x)F_2 \cdot aBaX_2:yEu^{2+}, zB$ [where $M^{II}$ is at least one of beryllium, magnesium, calcium, strontium, zinc, and cadmium; X is at least one of chlorine, bromine and iodine; $0.5 \leq a \leq 1.25, 0 \leq x \leq 1, 10^{-6} \leq y \leq 2 \times 10^{-1}$, and $0 < z \leq 10^{-1}$], as disclosed in Japanese Unexamined Patent Publication No. 57(1982)-23673.

The stimulable phosphor may also comprise phosphors expressed by the composition formula: $(Ba_{1-x}, M^{II}_x)F_2 \cdot aBaX_2:yEu^{2+}, zA$ [where $M^{II}$ is at least one of beryllium, magnesium, calcium, strontium, zinc, and cadmium; X is at least one of chlorine, bromine, and iodine; A is at least one of arsenic and silicon; $0.5 \leq a \leq 1.25, 0 \leq x \leq 1, 10^{-6} \leq y \leq 2 \times 10^{-1}$, and $0 < z \leq 5 \times 10^{-1}$], as disclosed in Japanese Unexamined Patent Publication No. 57(1982)-23675.

The stimulable phosphor may also comprise phosphors expressed by the composition formula: $(Ba_{1-x} M_{x/2} L_{x/2} FX:yEu^{2+}$ [where M is at least one alkaline metal selected from the group consisting of Li, Na, K, Rb, and Cs; L is at least one trihydric metal selected from the group consisting of Sc, Y, La, Ce, Pr, Nd, Pm, Sm, Gd, Tb, Dy, Ho, Er, Tm, Yb, Lu, Al, Ga, In, and Tl; X is at least one halogen selected from the group consisting of Cl, Br, and I; $10^{-2} \leq x \leq 0.5$, and $0 < y \leq 0.1$], as disclosed in Japanese Unexamined Patent Publication No. 58-(1983)-206678.

The stimulable phosphor may also comprise phosphors expressed by the composition formula: $BaFX \cdot xA:yEu^{2+}$ [where X is at least one halogen selected from the group consisting of Cl, Br, and I; A is a calcined tetrafluoroboric compound; $10^{-6} \leq x \leq 0.1$, and $0 < y \leq 0.1$], as disclosed in Japanese Unexamined Patent Publication No. 59(1984)-27980.

The stimulable phosphor may also comprise phosphors expressed by the composition formula: $BaFX \cdot xA:yEu^{2+}$ [where X is at least one halogen selected from the group consisting of Cl, Br, and I; A is at least one calcined compound selected from the group consisting of the salts of monohydric or dihydric metals of hexafluorosilicic acid, hexafluorotitanic acid, and hexafluorozirconic acid; $10^{-6} \leq x \leq 0.1$, and $0 < y \leq 0.1$], as disclosed in Japanese Unexamined Patent Publication No. 59-(1984)-47289.

The stimulable phosphor may also comprise phosphors expressed by the composition formula: $BaFX \cdot xNaX': aEu^{2+}$ [where each of X and X' is at least one of Cl, Br, and I; $0 < x \leq 2$, and $0 < a \leq 0.2$], as disclosed in Japanese Unexamined Patent publication No. 59(1984)-56479.

The stimulable phosphor may also comprise phosphors expressed by the composition formula: $M^{II}FX \cdot xNaX': yEu^{2+}$ [where $M^{II}$ is at least one alkaline earth metal selected from the group consisting of Ba, Sr, and Ca; each of X and X' is at least one halogen selected from the group consisting of Cl, Br, and I; A is at least one transition metal selected from the group consisting of V, Cr, Mn, Fe, Co, and Ni; $0 < x \leq 2, 0 < y \leq 0.2$, and $0 < z \leq 10^{-2}$], as disclosed in Japanese Unexamined Patent Publication No. 59(1984)-56480.

The stimulable phosphor may also comprise phosphors expressed by the composition formula: $M^{II}FX \cdot aM^I X' \cdot bM^{III}X'' \cdot cM^{III}X''{}'_3 \cdot xA:YEu^{2+}$ [where $M^{II}$ is at least one alkaline earth metal selected from the group consisting of Ba, Sr, and Ca; $M^I$ is at least one alkaline metal selected from the group consisting of Li, Na, K, Rb, and Cs; $M^{II}$ is at least one dihydric metal selected from the group consisting of Be and Mg; $M^{III}$ is at least one trihydric metal selected from the group consisting of Al, Ga, In, and Tl; A is a metal oxide; X is at least one halogen selected from the group consisting of Cl, Sr, and I; X', X'' and X''' are at least one halogen selected from the group consisting of F, Cl, Br, and I; $0 \leq a \leq 2$, $0 \leq b \leq 10^{-2}$, $0 \leq c \leq 10^{-2}$, and $a + b + c \geq 10^{-6}$ ; $0 < x \leq 0.5$ and $0 < y \leq 0.2$], as disclosed in Japanese Unexamined Patent Publication No. 59(1984)-75200 filed by the present applicant.

The stimulable phosphor may also comprise phosphors expressed by the composition formula: $M^{II}X_2 \cdot aM^{II}X'_2 : xEu^{2+}$ [where $M^{II}$ is at least one alkaline earth metal selected from the group consisting of Ba, Sr, and Ca; X and X' are at least one halogen selected from the group consisting of Cl, Br, and I with $X \neq X'$; $0.1 \leq a \leq 10.0$ and $0 < x \leq 0.1$], as disclosed in Japanese Unexamined Patent Publication No. 59(1984)-193161.

The stimulable phosphor which can be employed in the present invention is however not limited to the aforesaid phosphors, but may be any phosphor capable of photoluminescence upon exposure to stimulating light after it has been irradiated with a radiation.

Preferred thermoluminescent phosphors that can be used in the present invention include compounds produced by adding a small amount of at least one of Mn, Dy, and Tm to sulphuric compounds such as $Na_2SO_4$, $MnSO_4$, $CaSO_4$, $SrSO_4$, and $BaSO_4$.

The phosphor sheet may additionally have a protective layer and a light-reflecting or light-absorbing undercoated layer. The phosphor layer of the phosphor sheet may be colored with a pigment or a dye as disclosed in Japanese Unexamined Patent Publication No. 55(1980)-163500.

The above and other objects, features and advantages of the present invention will become more apparent from the following description when taken in conjunction with the accompanying drawings in which preferred embodiments of the present invention are shown by way of illustrative example.

BRIEF DESCRIPTION OF THE DRAWINGS

Figure 1 is a vertical cross-sectional view of a device for recording images produced by an electron microscope according to an embodiment of the present invention;

Figure 2 is a perspective view of an image reader system for reading an image out of a stimulable phosphor sheet on which an electron microscope image has been recorded by the device of the present invention;

Figure 3 is a schematic view of an example of an image reproducing apparatus which reproduces an electron microscope image recorded by the device of the present invention;

Figure 4 is a vertical cross-sectional view of a device for recording images produced by an electron microscope according to another embodiment of the present invention;

Figure 5 is a vertical cross-sectional view of a device for recording images produced by an electron microscope according to still another embodiment of the present invention; and

Figure 6 is a schematic view of an electron microscope which can be combined with the device of the present invention.

DESCRIPTION OF THE PREFERRED EMBODIMENTS

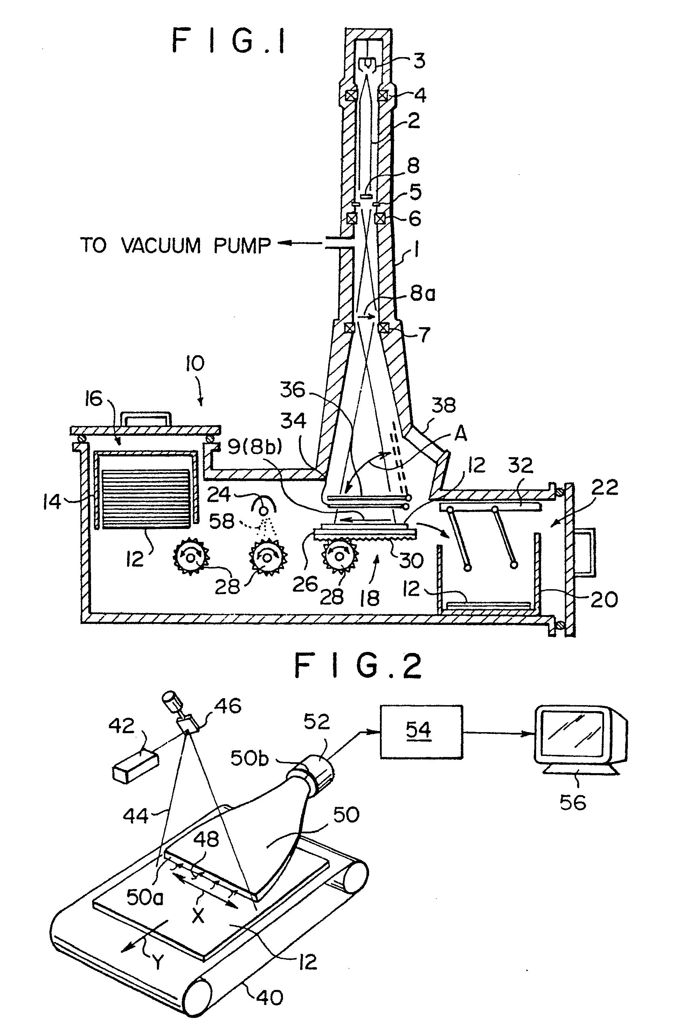

As shown in Figure 1, an electron microscope has a tubular lens barrel 1 housing an electron gun 3 for emitting an electron beam 2 at a uniform speed, at least one convergent lens 4 comprising a magnetic lens or an electrostatic lens for converging the electron beam 2 toward a specimen 8, a specimen support 5, an objective lens 5 identical to the convergent lens 4, and a projector lens 7. The electron beam 2 having passed through the specimen 8 placed on the specimen support 5 is deflected by the objective lens 6 to form a magnified scattered-light image 8a of the specimen 8. The magnified scattered-light image 8a is focused by the projector lens 7 as an image 8b on an image-formation plane 9.

An image recording device 10 according to the present invention is disposed below the tubular lens barrel 1. The image recording device 10 comprises a sensor supply unit 16 for storing a magazine 14 containing a number of stimulable phosphor sheets 12 serving as two-dimensional sensors, a recorder 18 including the image-formation plane 9, and a sensor receiving unit 22 for storing a magazine 20 identical to the magazine 14 in the sensor supply unit 16. An erase light source 24 is disposed between the sensor supply unit 16 and the recorder 18. A sheet supply table 26 is horizontally movably positioned between the sensor supply unit 16 and the recorder 18. The sheet supply table 26 has a rack 30 attached to the lower surface thereof and held in selective mesh with a plurality of pinions 28 spaced horizontally from each other. When the pinions 28 are rotated, therefore, the sheet supply table 26 can be moved horizontally between the sensor supply unit 16 and the recorder 18. The sensor receiving unit 22 has a sheet delivery arm 32 for holding the stimulable phosphor sheet 12 in the recorder 18 and feeding the stimulable phosphor sheet 12 downwardly into the magazine 20. Between the tubular lens barrel 1 and the image recording device 10, there are disposed a shutter 34 and a fluorescent screen 36 which can be angularly movable in the direction of the arrow A by levers (not shown). The lens barrel 1 has an observation window 38 of lead glass formed in a wall thereof at a position above the shutter 34.

The interiors of the lens barrel 1 and the image recording device 10 are kept under vacuum by a known vacuum pump while the electron microscope is in operation. The spaces in the lens barrel 1 and the image recording device 10 are isolated from each other by a shield (not shown) positioned between the lens barrel 1 and the image recording device 10. Therefore, the interior of the lens barrel 1 can be maintained under vacuum even when the interior of the image recording device 10 is vented to the atmosphere at the time of loading the magazine 14 or taking out the magazine 20.

For recording electron microscope images, the sensor supply unit 16 is loaded with the magazine 14 containing a number of stimulable phosphor sheets 12 and the sensor receiving unit 22 is loaded with the magazine 20 which is empty. The shutter 34 and the fluorescent screen 36 are held in a horizontal position (as shown) to shield the recorder 18 from the electron beam 2. The pinions 28 are rotated clockwise to move the sheet supply table 25 to the right for supplying the lowermost stimulable phosphor sheet 12 from the magazine 14 to the recorder 18. When the stimulable phosphor sheet 12 is thus supplied by the sheet supply table 26, the erase light source 24 is energized to erase any remanent radiation energy from the sheet 12 (as described later in more detail). The sheet supply table 26 is stopped when the sheet 12 reaches the image-formation plane 9. The electron beam 2 impinges on the fluorescent screen 36 to enable the same to emit fluorescent radiation in the form of the magnified scattered-light image 8a which can be observed through the observation window 38. After the focusing, magnification, and field of view of the magnified scattered-light image 8a have been determined by the operator while observing the image 8a through the observation window 38, the shutter 34 and the fluorescent screen 36 are lifted by the non-illustrated levers to the elevated position (indicated by the dotted lines). The electron beam 2 is now allowed to reach the stimulable phosphor sheet 12 set in the recorder 18. The electron beam energy which carries the magnified scattered-light image 8b is then stored in the sheet 12.

After the stimulable phosphor sheet 12 has been exposed to the electron beam 2, the shutter 34 is closed. The stimulable phosphor sheet 12 on which the magnified scattered-light image 8a is recorded is then fed by the sheet delivery arm 32 into the magazine 20. By reversing the pinions 28, the sheet supply table 26 is moved back from the recorder 18 to the sensor supply unit 16 for supplying another stimulable phosphor sheet 12 to the recorder 18 in the next recording cycle.

The foregoing cycle is repeated to store the stimulable phosphor sheets 12 with the images recorded thereon in the magazine 20. Upon completion of the desired recording process, the magazine 20 is removed from the sensor receiving unit 22, and the stimulable phosphor sheets 12 contained in the magazine 20 are processed for reading the recorded images therefrom. Figure 2 shows an image reader system for reading the recorded image from a stimulable phosphor sheet 12. As shown in Figure 2, the stimulable phosphor sheet 12 is positioned on a sheet transport means 40 comprising an endless belt, for example. A stimulating light beam 44 emitted from a stimulating light source 42 such as an He-Ne laser emission tube is deflected by a light deflector 46 such as a galvanometer mirror to scan the stimulable phosphor sheet 12 in the direction of the arrow X (primary scanning mode). At the same time, the sheet transport means 40 is operated to move the stimulable phosphor sheet 12 in the direction of the arrow Y (secondary scanning mode) which is substantially perpendicular to the primary scanning direction. Therefore, the entire surface of the stimulable phosphor sheet 12 is exposed to the stimulating light beam 44. Upon exposure to the stimulating light beam 44, the stimulable phosphor sheet 12 emits photofluorescent radiation 48 having a level dependent on the electron beam energy stored in the sheet 12. The emitted light 48 enters a light collector 50 through its entrance end 50a and goes through the light collector 50 while repeating total reflection therein. The light 48 is then discharged from the light collector 50 through its exit end 50b and detected by a light detector 52 such as a photomultiplier coupled to the exit end 50b. The photofluorescent light emitted from the stimulable phosphor sheet 12 is therefore photoelectrically read by the light detector 52. The electric signal produced by the light detector 52 is therefore representative of the level of the electron beam energy stored in the stimulable phosphor sheet 12. The electric signal from the light detector 52 is processed by an image processor 54, and then applied to an image reproducing unit 56 such as a display unit comprising a CRT. Alternatively, the image reproducing unit 56 may be a recording device for optically scanning a photosensitive film to record the image thereon. Therefore, the magnified scattered-light image 8b carried by the photofluorescent light 48 can be reproduced by the image reproducing unit 56.

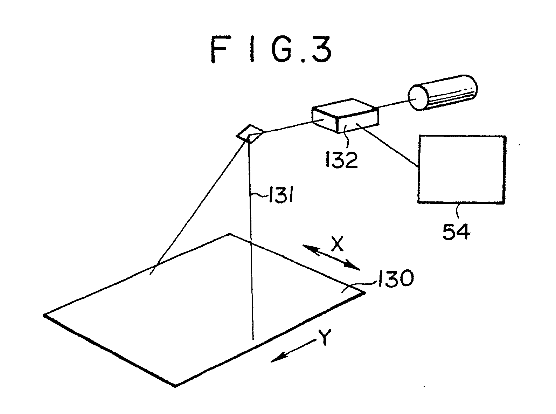

Figure 3 shows an example of an image scanner which can be used as the image reproducing unit 56. By moving a photosensitive film 130 in the sub-scanning direction of arrow Y and having a laser beam 131 scan the film 130 in the direction of the arrow X, and further by modulating the laser beam 131 by an A/D modulator 132 based on an image signal from the image processor 54, a visible image is formed on the photosensitive film 130.

The size of the visible image formed on the photosensitive film 130 is made larger than the size of the image-formation plane 9 (i.e., corresponding to the area of image recording on the two-dimensional sensor) and the magnified scattered-light image 8b is reproduced in an enlarged scale. Since the magnified scattered-light image 8b is reproduced with high sharpness when a stimulable phosphor sheet 10 is used, it is possible to reproduce an enlarged image of sufficiently high image quality. Therefore, it is possible to use a stimulable phosphor sheet 10 of small size and also possible to use a photodetector of small size, whereby the apparatus can be made compact in size.

When the image is reproduced in enlarged scale, the density of scanning lines is made higher in reproduction than that in read-out when the stored image is read out from the stimulable phosphor sheet. Specifically, when the image is read out of a small sized stimulable phosphor sheet, the density of scanning lines is preferably determined not lower than 10 pixels (picture elements)/mm, more preferably in the range of 15 pixels/mm to 100 pixels/mm, and when the image is reproduced the density of scanning lines is desired to be made lower, preferably in the range of 5 pixels/mm to 20 pixels/mm. Thus, enlarged images can be reproduced without lowering the quality of image.

When the stimulable phosphor sheet 12 is exposed to the stimulating light, not all of the electron beam energy stored in the sheet 12 is discharged, a remanent electron microscope image tending to remain on the sheet 12. In addition, the stimulable phosphor sheet 12 is liable to contain noise arising from environmental radiation or radiation from radioactive elements such as Ra mixed as impurities in the phosphor. To remove such a remanent image or noise, the stimulable phosphor sheet 12 as it is carried by the sheet supply table 26 is exposed to erasing light 58 emitted from the erase light source 24 as shown in Figure 1, the erasing light 58 being of a wavelength falling within the wavelength range of the stimulating light to be applied to the stimulable phosphor sheet 12. The residual radiation energy is therefore erased from the sheet 12 by exposure to the erasing light 58. The erase light source 24 may comprise a tungsten lamp, halogen lamp, an infrared lamp, a xenon flash lamp, or a laser beam source, as shown in Japanese Unexamined Patent Publication No. 56-(1981)-11392. The remanent image or noise can also be erased by heating the stimulable phosphor sheet 12.

The stimulable phosphor sheet 12 from which the image has been read can be recycled by being stored in the magazine 14 which is loaded in the sensor supply unit 16. The stimulable phosphor sheet 12 with the recorded image read therefrom may be processed by a separate erasing device having a light source similar to the erase light source 24. With such an alternative, the erase light source 24 in the image recording device 10 is employed primarily for erasing the small noise arising from the environmental radiation or radiation from radioactive elements such as radium (Ra) mixed as impurities in the phosphor, or a slight trace of the previously recorded image. The erase light source 24 can therefore be of a relatively small capacity. The amount of erasing light to be radiated onto the stimulable phosphor sheet 12 is shown in detail in Japanese Unexamined Patent Publication No. 58(1983)-80633, for example. Since the amount of erasing light to be emitted is equal to the product of illuminance and time, the desired amount of erasing light can be attained by varying the intensity of erasing light emitted from the erase light source 24 or the speed of travel of the stimulable phosphor sheet 12 below the erase light source 24.

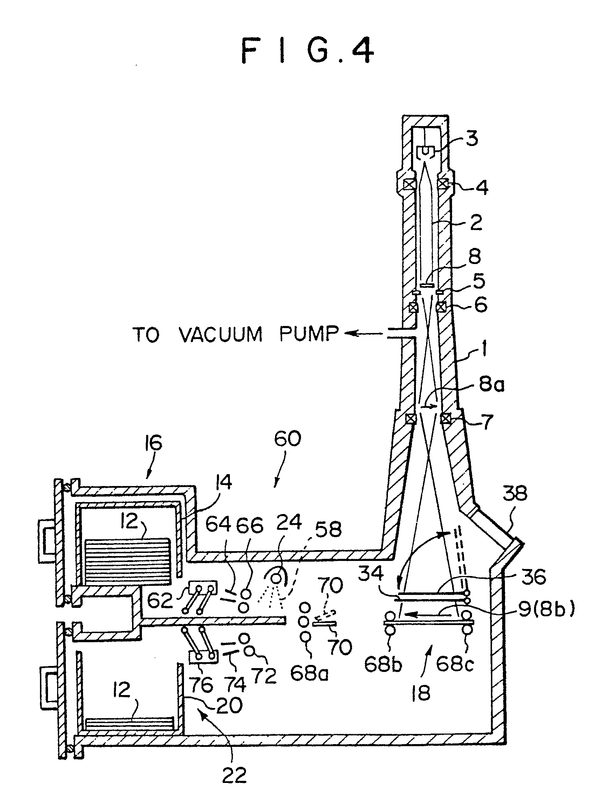

Figure 4 illustrates an image recording device 60 according to another embodiment of the present invention. In the image recording device 60, the sensor supply unit 16 and the sensor receiving unit 22 are vertically aligned. The stimulable phosphor sheets 12 in the magazine 14 loaded in the sensor supply unit 16 are removed one by one from the magazine 14 by a sheet feed arm 62 which grips the leading end of the sheet 12. The stimulable phosphor sheet 12 fed from the sensor supply unit 16 is then fed between two guide plates 64 and transported by sheet feed rollers 66 and sheet feed and discharge rollers 68a, 68b, 68c over a guide plate 70 to the recorder 18 which includes the image-formation plane 9. While the stimulable phosphor sheet 12 is being delivered from the sensor supply unit 16 to the recorder 18, the sheet 12 is exposed to the erasing light 58 emitted by the erase light source 24 to erase the residual radiation energy from the sheet 12. The stimulable phosphor sheet 12 is held in the image-formation plane 9 by the sheet feed and discharge rollers 68b, 68c in the recorder 18. The magnified scattered-light image 8b of the specimen 8 is then recorded on the stimulable phosphor sheet 12. After the image has been recorded, the sheet feed and discharge rollers 68b, 68c are reversed and the guide plate 70 is tilted to the dotted-line position to deliver the sheet 12 through the sheet feed rollers 68a and discharge rollers 72 and between two guide plates 74. The stimulable phosphor sheet 12 is then discharged into the magazine 20 in the sheet receiving unit 22 by a sheet discharge arm 76 which is identical to the sheet feed arm 62.

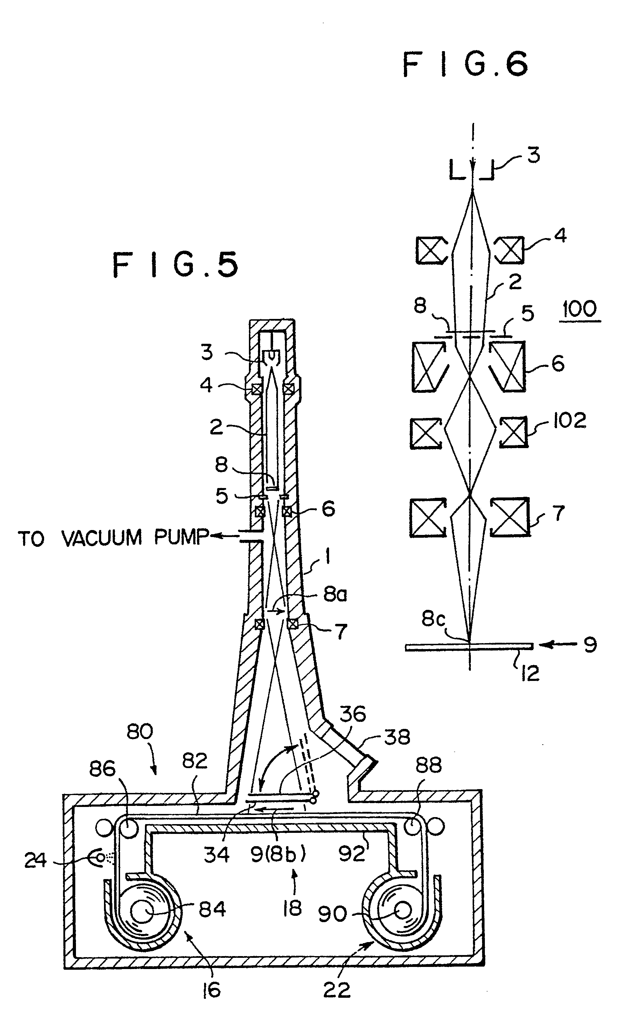

Figure 5 shows an image recording device 80 according to still another embodiment of the present invention. The image recording device 80 employs a belt-like stimulable phosphor sheet 82 serving as a two-dimensional sensor. The stimulable phosphor sheet 82 as it is wound around a sheet supply roll 84 is housed in the sensor supply unit 16. The stimulable phosphor sheet 82 is unwound from the sheet supply roll 84 and kept taut between sheet holder rollers 86, 88 so as to lie in the image-formation plane 9. The stimulable phosphor sheet 82 has its leading end engaging a sheet takeup roll 90 in the sensor receiving unit 22. When an electron microscope image is to be recorded on the stimulable phosphor sheet 82, the sheet takeup roll 90 is rotated to deliver the sheet 82 a prescribed length from the sheet supply roll 84 to the sheet takeup roll 90. By successively feeding the stimulable phosphor sheet 82 through the recorder 18, magnified scattered-light images 8b are successively recorded on successive areas of the stimulable phosphor sheet 12. The stimulable phosphor sheet 12 as it is fed from the sheet supply roll 84 to the recorder 18 is exposed to the erasing light 58 from the erase light source 24 for thereby erasing undesired remanent radiation energy from the sheet 82.

When the stimulable phosphor sheet 82 is fully consumed and wound up by the sheet takeup roll 90, it is removed together with the sheet takeup roll 90 from the sensor receiving unit 22, or is wound back on the sheet supply roll 84 and removed together with the sheet supply roll 84 from the sheet supply unit 16. The stimulable phosphor sheet 82 is then processed by the image reader system in the manner described above. In the arrangement shown in Figure 5, the stimulable phosphor sheet 82 in the sensor supply unit 16, the recorder 18, and the sensor receiving unit 22 is shielded from light by a shield 92. Thus, the erase light source 24 may be energized at all times. From the economical standpoint, however, the erase light source 24 should be energized only for required time periods.

The erase light source 24 in each of the foregoing embodiments may be located outside of the image recording device, and the stimulable phosphor sheet may be exposed to erasing light transmitted from the erase light source 24 through a light-transmissive window in the wall of the image recording device.

The image recording device of the present invention can be used for recording the diffraction pattern of a specimen. Figure 6 shows an electron microscope which can be employed in combination with the image recording device for recording such a diffraction pattern. The electron microscope, generally denoted at 100, has an intermediate lens 102 disposed between the objective lens 6 and the projector lens 7. The diffraction pattern 8c of the specimen 8, which is formed on the rear focal plane of the objective lens 7, is magnified by the intermediate lens 102 and the projector lens 7 with their focal points on the rear focal plane of the objective lens 7 and is projected onto the image-formation plane 9. By placing the stimulable phosphor sheet 12 in the image-formation plane 9, the magnified image of the diffraction pattern 8c can be recorded by the electron beam 2 on the stimulable phosphor sheet 12. The recorded diffraction pattern 8c can be reproduced by the image reader system shown in Figure 2, and the reproduced image can be displayed on the CRT or printed as a hard copy.

The stimulable phosphor sheet may comprise a thermofluorescent phosphor sheet. For discharging the stored energy from the thermofluorescent phosphor sheet, the sheet may be scanned by thermal radiation emitted from a heat source such as a $CO_2$ laser source. For more details, reference should be made to Japanese Patent Publication No. 55(1980)-47720.

The image recording device of the present invention is highly advantageous for the following reasons:

Since an electron microscope image is recorded on a high-sensitivity two-dimensional sensor in the form of a stimulable phosphor sheet, for example, the electron microscope image can be recorded with high sensitivity, so that the intensity of the electron beam for exposing the two-dimensional sensor can be lowered and hence exposure-induced damage to the specimen can be reduced.

The recorded electron microscope image is reproduced directly as an electric signal, which can be processed in various ways such as tone processing, frequency emphasis, etc. By processing the electric signal with a computer, various image processing modes such as the processing of a diffraction pattern, the reconstruction of a three-dimensional image, and the digitization of an image can easily and quickly be effected.

Since the two-dimensional sensor for recording electron microscope images can be reused through exposure to erasing light or heat, electron microscope images can be recorded more economically than would be with the conventional silver-salt photographic system.

Many electron microscope images can successively be recorded on separate two-dimensional sensors or a single belt-like two-dimensional sensor in an automatic process by feeding the successive two-dimensional sensors or the single two-dimensional sensor from the sensor supply unit through the recorder into the sensor receiving unit. The recorded electron microscope images are of a good S/N ratio as undesired remanent images and noise are erased before the images are recorded.

Although certain preferred embodiments have been shown and described, it should be understood that many changes and modifications may be made therein without departing from the scope of the appended claims.

## Claims

1. A device for recording images produced by an electron microscope, comprising:

i) a sensor supply unit (16) for supplying a two-dimensional sensor comprising a stimulable phosphor sheet (12) capable of storing electron beam energy;

ii) a recorder (18) for holding the stimulable phosphor sheet (12) on the image formation plane (9) of the electron microscope and for recording an electron beam image (8b) transmitted through a specimen (8) on the two-dimensional sensor;

iii) a sensor receiving unit (22) for accommodating the stimulable phosphor sheet (12) having the electron beam image (8b) recorded thereon;

iv) sensor feed means (26) for feeding the stimulable phosphor sheet (12) from said sensor supply unit (16) to said recorder (18);

v) sensor delivery means (32) for delivering the stimulable phosphor sheet (12) from said recorder (18) to said sensor receiving unit (22) after the electron beam image (8b) has been recorded on the stimulable phosphor sheet (12) in said recorder (18); and

vi) erase means (24) disposed between said sensor supply unit (16) and said recorder (18) for heating or irradiating the stimulable phosphor sheet (12) with light to discharge residual radiation energy stored in the stimulable phosphor sheet.

2. A device according to claim 1, wherein said sensor supply unit (16) comprises a magazine (14) for storing a plurality of stimulable phosphor sheets (12) and said sensor receiving unit (22) comprises a magazine (20) for receiving the stimulable phosphor sheet (12) delivered from said sensor supply unit (16) through said recorder (18) by said sensor feed (26) and delivery means (32).

3. A device according to claim 1, wherein said sensor supply unit (16) comprises a supply roll (84) for winding thereon a belt-like stimulable phosphor sheet (82) and said sensor receiving unit (22) comprises a takeup roll (90) for winding thereon the belt-like stimulable phosphor sheet (82) delivered from said sensor supply unit (16) through said recorder (18) by said sensor feed and delivery means.

## Revendications

1. Dispositif pour enregistrer des images produites par un microscope électronique, comprenant :

i) une unité de fourniture de détecteurs (16) pour fournir un détecteur bidimensionnel comprenant une feuille de substance fluorescente stimulable (12) susceptible de stocker l'énergie d'un faisceau d'électrons ;

ii) un enregistreur (18) pour tenir la feuille de substance fluorescente stimulable (12) sur le plan de formation d'images (9) du microscope électronique et pour enregistrer une image du faisceau d'électrons (8b) transmis à travers un échantillon (8) sur le détecteur bidimensionnel ;

iii) une unité de réception de détecteurs (22) pour recevoir la feuille de substance fluorescente stimulable (12) sur laquelle est enregistrée l'image du faisceau d'électrons (8b) ;

iv) des moyens d'amenée de détecteurs (26) pour amener la feuille de substance fluorescente stimulable (12) depuis l'unité de fourniture de détecteurs (16) à l'enregistreur (18) ;

v) des moyens de livraison de détecteurs (32) pour livrer la feuille de substance fluorescente stimulable (12) de l'enregistreur (18) à l'unité de récepteur de détecteurs (22) après enregistrement de l'image du faisceau d'électrons (8b) sur la feuille de substance fluorescente stimulable (12) dans l'enregistreur (18) ; et

vi) des moyens d'effacement (24) disposés entre l'unité de fourniture de détecteurs (16) et l'enregistreur (18) pour chauffer ou irradier la feuille de substance fluorescente stimulable (12) avec une lumière pour évacuer l'énergie de rayonnement résiduelle stockée dans la feuille de substance fluorescente stimulable.

2. Dispositif selon la revendication 1, dans lequel l'unité de fourniture de détecteurs (16) comprend un magasin (14) pour stocker une multiplicité de feuilles de substance fluorescente stimulable (12) et dans lequel l'unité de réception de détecteurs (22) comprend un magasin (20) pour recevoir la feuille de substance fluorescente stimulable (12) amenée de l'unité de fourniture de détecteurs (16) à travers l'enregistreur (18) par les moyens d'amenée (26) et les moyens de livraison (32) des détecteurs.

3. Dispositif selon la revendication 1, dans lequel l'unité de fourniture de détecteurs (16) comprend un rouleau de fourniture (84) sur lequel est enroulée une feuille de substance fluorescente stimulable analogue à une bande (82) et dans lequel l'unité de réception de détecteurs (22) comprend un rouleau de reprise (90) pour enrouler sur lui la feuille de substance fluorescente stimulable analogue à une bande (82) amenée de l'unité de fourniture de détecteurs (16) à travers l'enregistreur (18) par les moyens d'amenée et de livraison de détecteurs.

**Ansprüche**

1. Vorrichtung zur Aufzeichnung von Bildern, die von einem Elektronenmikroskop erzeugt wurden, welche umfaßt:

   I) eine Sensorzufuhreinheit (16) zur Zufuhr eines zweidimensionalen Sensors, der eine anregbare Leuchtstoffplatte (12) umfaßt, die die Energie des Elektronenstrahls speichern kann,

   II) ein Registrierinstrument (18) zum Halten der anregbaren Leuchtstoffplatte (12) auf der Bildausbildungsebene (9) des Elektronenmikroskops und zur Aufzeichnung eines Elektronenstrahlbildes (8b), das durch die Probe (8) auf den zweidimensionalen Sensor übertragen wurde,

   III) eine Sensoraufnahmeeinheit (22) zur Aufnahme der anregbaren Leuchtstoffplatte (12) mit dem darauf aufgezeichneten Elektronenstrahlbild (8b),

   IV) eine Sensorführungseinrichtung (26) zur Führung der anregbaren Leuchtsoffplatte (12) von der Sensorzufuhreinheit (16) zum Registrierinstrument (18),

   V) eine Sensorübergabeeinrichtung (32) zur Übergabe der anregbaren Leuchtstoffplatte (12) vom Registrierinstrument (18) zur Sensoraufnahmeeinheit (22), nachdem im Registrierinstrument (18) auf der anregbaren Leuchtstoffplatte (12) ein Elektronenstrahlbild (8b) aufgezeichnet wurde, und

   VI) eine Löscheinrichtung (24), die zwischen der Sensorzufuhreinheit (16) und dem Registrierinstrument (18) angeordnet ist, um die anregbare Leuchtstoffplatte (12) mit Licht zu erwärmen oder zu bestrahlen, um die restliche Strahlungsenergie, die in der anregbaren Leuchtstoffplatte gespeichert ist, zu entladen.

2. Vorrichtung nach Anspruch 1, worin die Sensorzufuhreinheit (16) ein Magazin (14) zur Lagerung einer Vielzahl von anregbaren Leuchtstoffplatten (12) umfaßt und die Sensoraufnahmeeinheit (22) ein Magazin (20) zur Aufnahme der anregbaren Leuchtstoffplatte (12) umfaßt, die durch die Sensorführungseinrichtung (26) und die -übergabeeinrichtung (32) von der Sensorzufuhreinheit (16) durch das Registrierinstrument (18) zugeführt wird.

3. Vorrichtung nach Anspruch 1, worin die Sensorzufuhreinheit (16) eine Zufuhrwalze (84) umfaßt, um eine bandförmige anregbare Leuchtstoffplatte (82) darauf aufzuwickeln, und die Sensoraufnahmeeinheit (22) eine Aufnahmewalze (90) umfaßt, um die bandförmige anregbare Leuchtstoffplatte (82) darauf aufzuwickeln, die durch die Sensorführungs- und -übergabeeinrichtung von der Sensorzufuhreinheit (16) durch das Registrierinstrument (18) zugeführt wird.

EP 0 181 507 B1

# F I G . I

TO VACUUM PUMP

# F I G . 2

11

# F I G.3

132

~131

X

~130

Y

54

EP 0 181 507 B1

# F I G . 4

TO VACUUM PUMP ←

F I G.6

F I G.5

TO VACUUM PUMP